# EUROPÄISCHE PATENTSCHRIFT

(11) **EP 0 664 050 B1**
(45) Veröffentlichungstag und Bekanntmachung des Hinweises auf die Patenterteilung: **14.10.1998**
(21) Anmeldenummer: 94925387.6
(22) Anmeldetag: 25.07.1994
(51) Int. Cl.: H01L 21/00

(54) **VORRICHTUNG ZUM TRANSPORT VON WAFERMAGAZINEN**
DEVICE FOR TRANSPORTING WAFER MAGAZINES
DISPOSITIF DE TRANSPORT POUR MAGASINS A GALETTES

(30) Priorität: 05.08.1993 DE 4326309
(43) Veröffentlichungstag der Anmeldung: 26.07.1995
(73) Patentinhaber: JENOPTIK Aktiengesellschaft, 07739 Jena (DE)
(72) Erfinder: ADLER, Erich, D-07747 Jena (DE); MAGES, Marlies, D-07745 Jena (DE)
(74) Vertreter: Geyer, Werner, Dr.-Ing.
(86) Internationale Anmeldenummer: EP9402447
(87) Internationale Veröffentlichungsnummer: WO9505003

(56) Entgegenhaltungen:
- EP-A- 0 340 345
- EP-A- 0 552 756
- PATENT ABSTRACTS OF JAPAN vol. 16, no. 397 (E-1252) 24. August 1992 & JP,A,04 130 617 (ULVAC JAPAN LTD) 1. Mai 1992

## Beschreibung

Die Erfindung betrifft eine Vorrichtung zum Transport von Wafermagazinen mit einem Fahrstuhl zwischen einer oberen Entnahmeposition aus einem Magazinbehälter und einer unteren Abstellposition, von der aus eine Umsetzung zu mindestens einem Bearbeitungsplatz erfolgt.

Unter dem Namen SMIF (Standard Mechanical Interface) bekannt gewordene Systeme, die bevorzugt bei der Herstellung von Halbleiterchips eingesetzt werden, beinhalten eine sogenannte SMIF- Box als Magazinbehälter mit einem relativ kleinen abgeschlossenen Volumen, in dem Wafermagazine aufbewahrt und transportiert werden können. Die Box ist auf einen Öffnungsmechanismus in einer Einhausung aufsetzbar, die eine oder mehrere Arbeitstationen staubgeschützt umschließt. Box und Öffnungsmechanismus besitzen einander angepaßte Verschlußelemente, die übereinanderliegend sich gleichzeitig öffnen lassen, so daß außen auf den Verschlußelementen aufliegende Staubpartikel dazwischenliegend eingeschlossen werden, wenn das Wafermagazin zusammen mit den beiden Verschlußelementen in die Einhausung hinein abgesenkt wird. Die Box selbst umschließt die entstehende Öffnung in der Einhausung.
Nachdem das Magazin abgesetzt ist, macht sich in der Regel eine Umsetzung innerhalb der Einhausung notwendig für deren Ausführung verschiedene technische Lösungen bekannt geworden sind.
So wird nach EP 209 660 eine Kassette durch einen automatisierten Kassettenmanipulator von einem SMIF-Fahrstuhl zu einem Gerätefahrstuhl transportiert, indem eine Schwenkbewegung während der senkrechten Auf- oder Abbewegung der Kassette eingesetzt wird. Durch den Einsatz von Drehelemente soll das Maß der Partikelerzeugung gegenüber linear sich bewegenden Elementen herabgesetzt werden. Ähnliche Lösungen sind auch in EP 238 541 beschrieben, bei denen das Umsetzen des Magazins über vorgegebene Bewegungskurven durch den Einsatz motorisch angetriebener Hebelarme erfolgt, die mit einem seperaten Lift in z-Richtung verfahren werden.
Durch die mechanische Ausführung der bekannten Lösungen, insbesondere den seitlich am Magazin vorbeiführten Wirkbereich des als Hebelarm ausgebildeten Umsetzers bzw. den geschlossenen Aufbau wird die zum Erhalt des Reinstraumes erforderliche Laminarluflströmung stark gestört oder verhindert.

Die Kopplung der Umsetzbewegung mit der z-Bewegung verlängert unnötig die Transportzeiten und erhöht die Parükelgenerierung.

Mit den bekannten Lösungen ist es insbesondere bei der Nachrüstung von Maschinen der Halbleiterindustrie schwierig, bereits bestehende Reinsträume mit dem SMIF-System zu komplettieren, so daß Wafermagazine unter SMIF-Bedingungen in die Maschinen eingebracht und dort unter Reinstraumbedingungen entpackt und transportiert werden können.

Aufgabe der Erfindung ist es deshalb, auch für eine Lösung, bei der die Manipulationseinrichtung über zwei voneinander trennbare beziehungsweise wahlweise zusammensetzbare Bereiche wirken muß, eine durch die Manipulation mögliche Partikelgenerierung und eine Störung der Laminarluftströmung des Reinstraumes durch die Manipulationseinrichtung weitgehend auszuschließen.

Gemäß der Erfindung wird die Aufgabe durch eine Vorrichtung zum Transport von Wafermgazinen nach Anspruch 1 gelöst.

Vorteilhafte Ausführungen sind in den Ansprüchen 2-7 beschrieben.

Die Wesensmerkmale der Erfindung gestatten einen modularen Aufbau der Vorrichtung, wodurch eine Anpassung an damit auszurüstende Halbleiterbearbeitungsmaschinen gewährleistet ist.

Zur Positionierung aus dem Magazin herausragender scheibenförmiger Objekte ist eine Waferrückflüweinrichtung vorgesehen, deren Wirksamwerden an ein Sensorsignal eines Crashsensors gebunden ist, dessen Meßstrahlenbündel parallel zu den scheibenförmigen Objekten gerichtet und beim Verfahren des Magazins dessen zur Entnahme und Beschickung dienenden Seite unmittelbar benachbart ist.

Vorteilhafterweise entsteht durch eine Einhausung ein abgekapselter Transportraum. Die Einhausung selbst bildet ein Koppelelement zu einer Halbleiterbearbeitungsmaschine, wodurch ein maschineninternes Klima weitgehend ungestört bleibt.

Eine innerhalb der Einhausung zusätzlich untergebrachte Lüfter-Filter-Einheit erzeugt einen Laminarluflstrom, der entweder senkrecht oder parallel zur Bewegungsrichtung des Linearantriebes gerichtet ist.

Es ist auch möglich, die Einrichtung zu nutzen die das maschineninterne Klima erzeugt.

Die Erfindung soll nachstehend anhand der schematischen Zeichnung näher erläutert werden. Es zeigen:
- Fig. 1: eine Gesamtansicht einer erfindungsgemäßen Vorrichtung von vorn
- Fig. 2: die Vorrichtung von hinten

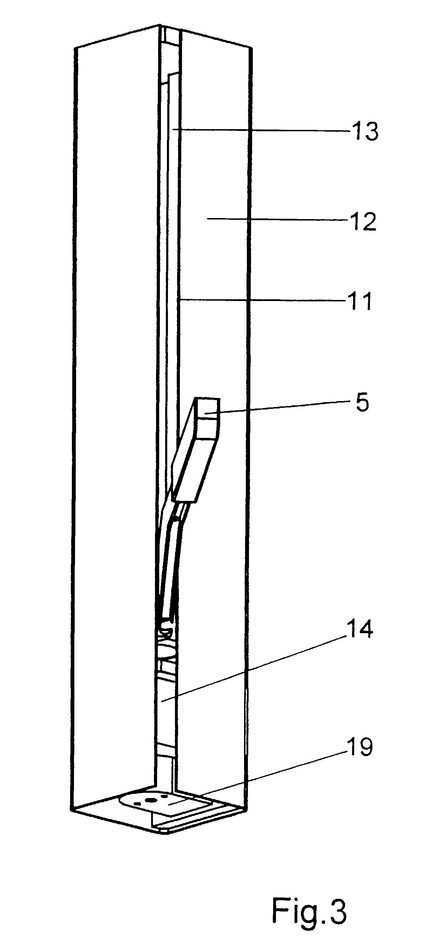

- Fig. 3: einen Fahstuhl mit Verkleidung

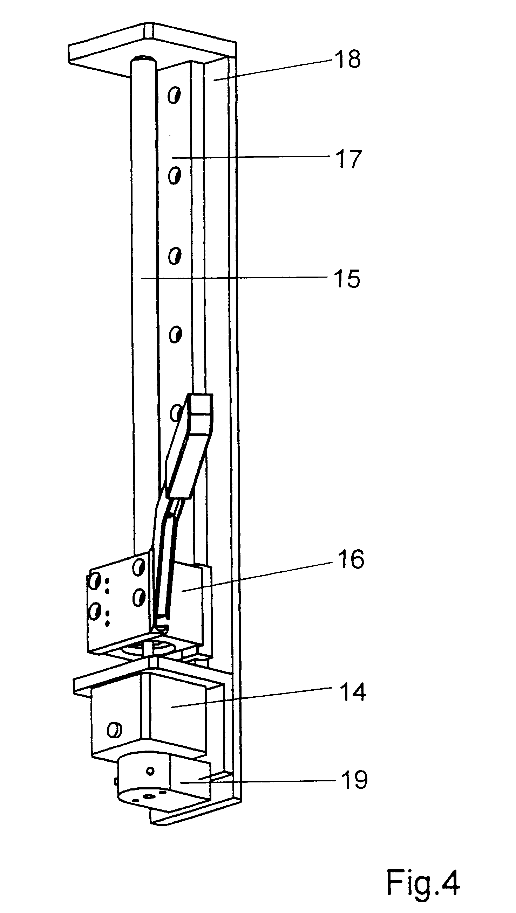

- Fig. 4: einen unverkleideten Fahrstuhl
- Fig. 5: einen unverkleideten Linearantrieb
- Fig. 6: teilweise im Schnitt einen Linearantrieb mit Greifarm und greifenden Elementen
- Fig. 7: die Vorrichtung mit umschließendem Gehäuse

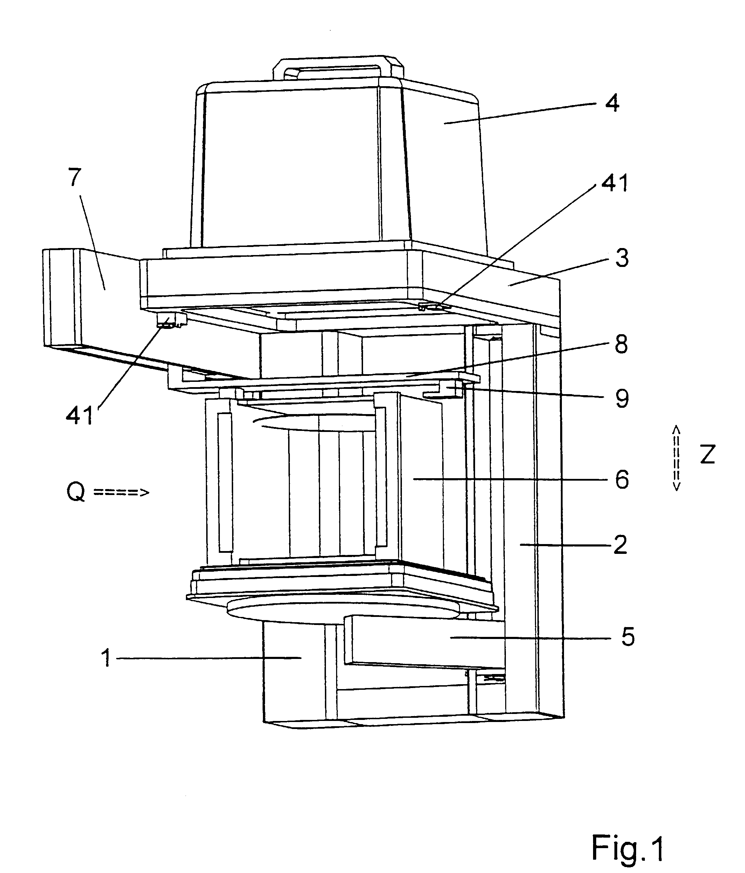

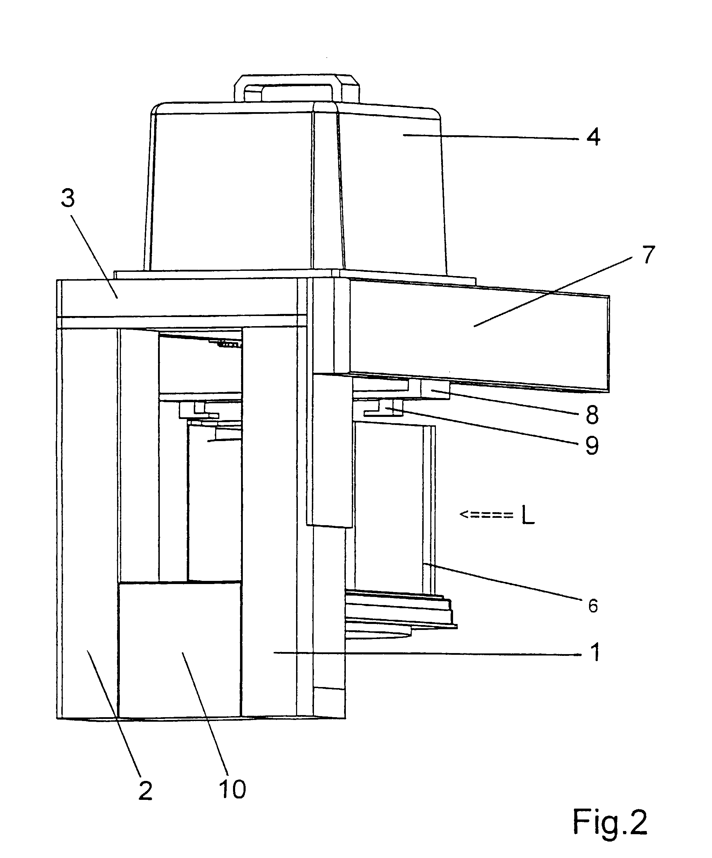

In Fig. 1 dienen eine tragende Säule 1 und ein verkleideter Fahrstuhlantrieb 2 eines Fahrstuhles, deren Abstand zueinander eine Luftdurchtrittsöffnung darstellt, als Abstützelemente für eine Aufnahmeplatte 3, auf die ein Magazinbehälter 4 mit einem entriegelbaren Boden abgestellt ist. Ein durch den Fahrstuhlantrieb 2 in z-Richtung verfahrbarer Aufnahmearm 5 ist vorgesehen, um die Entnahme und Rückführung eines in dem Magazinbehälter 4 befindlichen Magazins 6 für waferartige Objekte auszuführen. An der tragenden Säule 1 ist ein Linearantrieb 7 für einen starren Greiferarm 8 befestigt, dessen Aktionsbereich, wie in Fig. 1 dargestellt, oberhalb des sich in einer unteren Abstellposition befindlichen Magazins 6 liegt und senkrecht zur Fahrtrichtung des Fahrstuhlantriebes 2 gerichtet ist. Der Greiferarm 8 ist mit greifenden Elementen 9 versehen, die zur Ausführung der Greiffunktion zusammen mit dem Linearantrieb 7 höhenverstellbar (z - Richtung) sind.
In einer zwischen der Säule 1 und dem Fahrstuhlantrieb 2 bestehenden Verbindung 10 (Fig. 2) und im unteren Teil der Säule 1 sind nicht dargestellte Steuerelemente für den Linearantrieb 7 und dessen Hubfunktion sowie den Greiferarm 8 mit seinen greifenden Elementen 9 und eine Absaugung untergebracht.
Nicht dargestellt sind außerdem ein unter der Säule 1 und dem Fahrstuhlantrieb 2 befindliches mechanisches Interface zur Anpassung an eine Maschine, mit der die Vorrichtung verbunden werden soll. Im Bereich der Aufnahmeplatte 3 sind Bedien- und Anzeigeelemente angebracht. Eine externe Steuerelektronik besitzt eine Kabelverbindung zu der Vorrichtung.
Die gesamte Vorrichtung gemäß Fig. 1 und 2 besteht aus einzelnen Modulen, wie den Fahrstuhlantrieb 2, die Aufnahmeplatte 3 für den Magazinbehälter 4, den Linearantrieb 7 mit dem Greiferarm 8 und den greifenden Elementen 9 sowie Sensoren für Erkennung und Sicherheit, die entsprechend den Einsatzbedingungen unter Beibehaltung der Wesensmerkmale der Vorrichtung miteinander verbunden werden können. Das Magazin 6 kann in den mit Pfeilen L und Q markierten Richtungen von einer laminaren Luft- oder Gasströmung durchsetzt werden, ohne daß behindernde Bauteile diese Strömung stören.

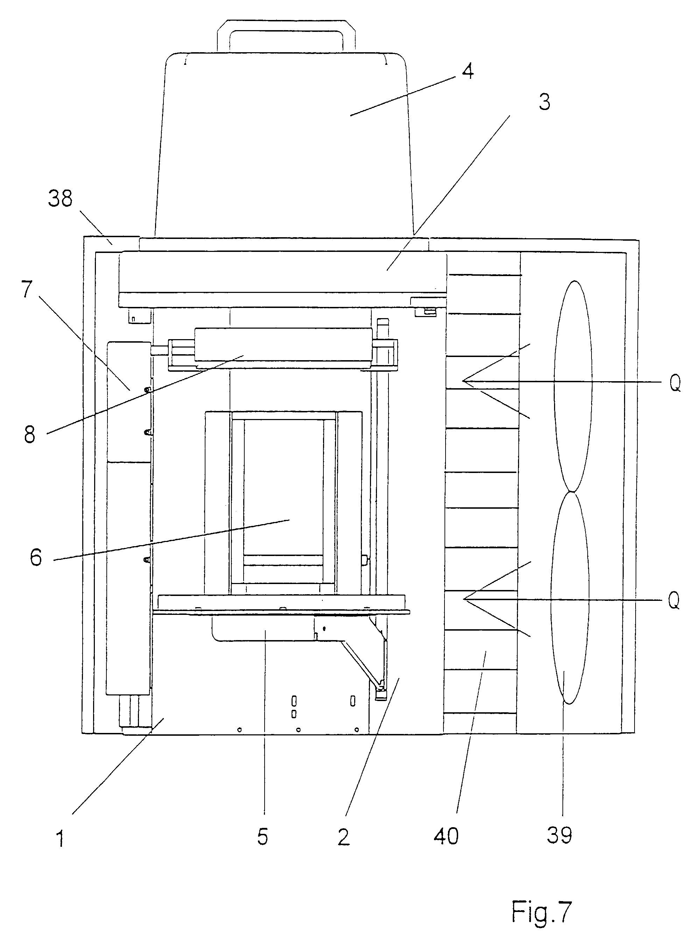

Der Fahrstuhlantrieb 2 ist bis auf eine schlitzförmige Öffnung 11, durch die der Aufnahmearm ragt, von einer als Kapselung ausgebildeten Verkleidung 12 umschlossen. Eine Absaugvorrichtung 13 in Form von Profilhohlkörpern beiderseits der Öffnungen 11 erstreckt sich über deren gesamte Länge.
Die Profilhohlkörper sind mit einer Vakuumerzeugungseinrichtung verbunden, von der immer nur soviel Gas abgesaugt wird, daß keine Störung der Laminarluftströmung des Innenraumes, wie er z.B. in Fig. 7 dargestellt ist, erfolgt, generierte Partikel aber abgesaugt werden.

Innerhalb der Verkleidung 12 besteht der Fahrstuhlantrieb 2 aus einer durch einen Motor 14 angetriebenen Spindel 15, auf der eine mit dem Aufnahmearm 5 gekoppelte Spindelmutter 16 in einer Führung 17 läuft. Die Führung 17 ist auf einem Träger 18 montiert. Der Motor 14 besitzt einen Encoder 19.

Nicht dargestellte Sensoren überwachen die obere und untere Endlage des Fahrbereiches.

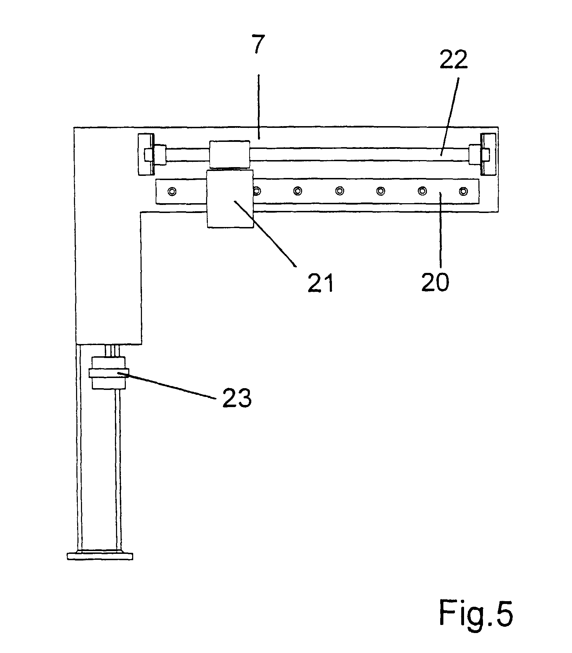

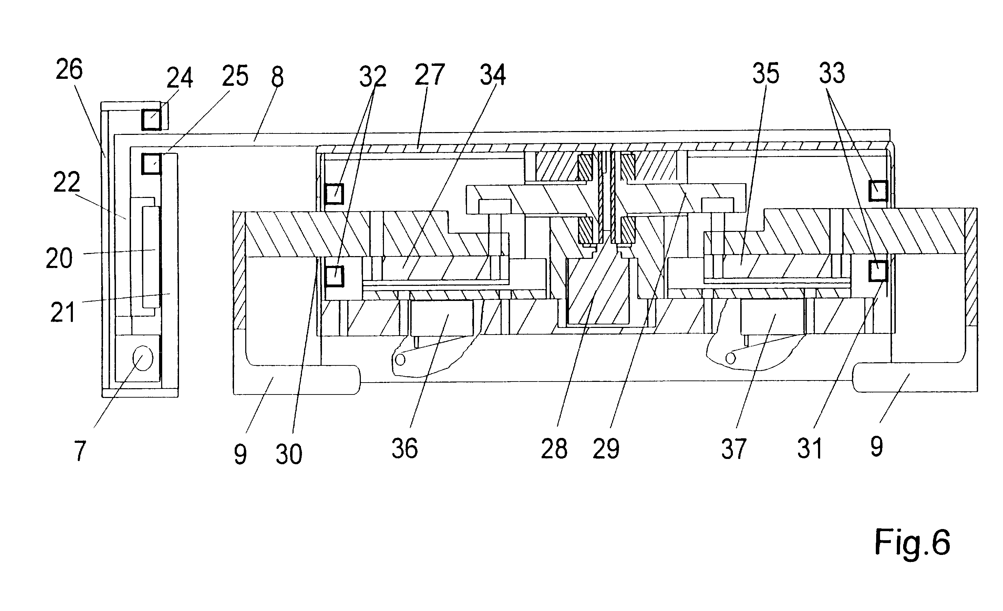

Der Linearantrieb 7 enthält nach Fig. 5 eine gestellfest montierte Führung 20 für eine Greiferarmbefestigung 21 des Greiferarms 8, die gleichzeitig mit einem Antriebselement 22 des Linearantriebes 7 in Verbindung steht.
Für die Höhenverstellung des in der Säule 1 entsprechend geführten Linearantriebes 7 ist ein Antriebselement in Form eines Hubzylinders 23 im unteren Teil der Säule 1 angebracht. Die Endlagenkontrolle erfolgt sensorisch.
Der an der Greiferarmbefestigung 21 sitzende Greiferarm 8 ist durch einen Schlitz in einer Verkleidung 26 nach außen geführt, zu dessen beiden Seiten über die gesamte Länge, analog dem Fahrstuhlantrieb 2, in Fig. 6 mit 24, 25 bezeichnete Absaugvorrichtungen angeordnet sind.
Der Greiferarm 8 besitzt in einem Gehäuse 27 einen Antrieb für die greifenden Elemente 9, der aus einem Motor 28 und einer Kurvenscheibe 29 besteht. An Austrittsöffnungen 30, 31 des Gehäuses 27 sind Absaugvorrichtungen 32, 33 angebracht. Mikroführungen 34, 35 dienen der parallelen Bewegung der greifenden Elemente 9. Nicht dargestellte Endlagenschalter überwachen die Endlage der Elemente 9 und z.B. Rollenmikroschalter 36, 37 die Greiferposition.

In Fig. 7 ist in einer aus reinraumgerechten Material bestehenden, einen Magazinumsetzraum bildenden Einhausung 38 zusammen mit der erfindungsgemäßen Vorrichtung ein Lüfter 39 und eine Filter 40 untergebracht. Durch den Lüfter 39 angesaugte Reinluft wird über das Filter 40 entsprechend der Reinraumklasse gefiltert und durchsetzt das Magazin 6.

Mit der erfindungsgemäßen Vorrichtung wird, nachdem der Magazinbehälter 4 auf der Aufnahmeplatte 3 abgestellt und der Boden des Magazinbehälters 4 entriegelt ist, das Magazin 6 zusammen mit dem Boden und einem Verschlußelement in der Aufnahmeplatte 3 durch den Fahrstuhl von einer oberen Entnahmeposition in eine untere Abstellposition gefahren.
Der Greiferarm 8 steht während dieses Vorganges außerhalb des Fahrstuhlbewegungsreiches über einem Bearbeitungsplatz .
Nach Erreichen der unteren Abstellposition wird der Greiferarm durch den Linearantrieb 7 oberhalb des Magazins 6 zu diesem hinbewegt. Der Hubzylinder 23 senkt den Greiferarm 8 mit seinen greifenden Elementen 9 ab. Nachdem die Rollenmikroschalter 36, 37 die Lage des Magazins 6 detektiert haben, schließen die greifenden Elemente 9, und das Magazin wird über den Hubzylinder 23 angehoben. Mit dem Linearantrieb 7 erfolgt der Transport zum Bearbeitungsplatz.

Zur Positionierung aus dem Magazin 6 herausragender scheibenförmiger Objekte ist eine Waferrückführeinrichtung vorgesehen, deren Wirksamwerden an ein Sensorsignal eines Crash-Sensors 41 gebunden ist, dessen Meßstrahlenbündel parallel zu den scheibenförmigen Objekten gerichtet und beim Verfahren des Magazins 6 in z-Richtung dessen zur Entnahme und Beschickung dienenden Seite unmittelbar benachbart ist.

Die Waferrückführeinrichtung führt, ausgelöst durch das Sensorsignal, die scheibenförmigen Objekte ohne äußere Eingriffe in das Magazinfach zurück. Ohne einen manuellen Eingriff wird ein Weitertransport des Magazins 6 in den Magazinbehälter 4 gewährleistet und eine Beschädigung herausragender scheibenförmiger Objekte vermieden.

## Patentansprüche

1. Vorrichtung zum Transport von Wafermagazinen, die in einem Magazinbehälter auf einem entriegelbaren Boden abgestellt sind und zusammen mit einem Verschlußelement einer Aufnahmeplatte ein Transportobjekt für einen aus Fahrstuhlantrieb und Aufnahmeelement bestehenden Fahrstuhl zwischen einer oberen Entnahmeposition und einer unteren Abstellposition bilden, von der aus eine Umsetzung zu mindestens einem Bearbeitungsplatz erfolgt,
**dadurch gekennzeichnet,**
daß in einem Abstand zum Fahrstuhlantrieb (2) eine tragende Säule (1) unter Ausbildung einer Luftdurchtrittsöffnung zwischen beiden vorgesehen ist, wobei an der tragenden Säule (1) zum Umsetzen des Magazins (6) ein in Verfahrrichtung (z) des Fahrstuhles höhenverstellbarer Linearantrieb (7) für einen starren, mit greifenden Elementen versehenen Greiferarm (8) angebracht ist, der bei in Abstellposition befindlichem Magazin (6) oberhalb desselben liegt, einen Antrieb (28,29) für die greifenden Elemente (9) trägt und durch den Linearantrieb (7) senkrecht zur Verfahrrichtung (z) des Fahrstuhles bewegbar ist, und daß der Fahrstuhlantrieb (2), sowie der Linearantrieb (7) mit Greiferarm (8), greifenden Elementen (9) und deren Antrieb (28,29) jeweils als staubdicht gekapselte Module ausgebildet sind.

2. Vorrichtung nach Anspruch 1, dadurch gekennzeichnet, daß zur Positionierung aus dem Magazin (6) herausragender scheibenförmiger Objekte eine Waferrückführeinrichtung vorgesehen ist, deren Wirksamwerden an ein Sensorsignal eines Crash-Sensors (41) gebunden ist, der ein parallel zu den scheibenförmigen Objekten gerichtetes Meßstrahlenbündel aufweist und beim Verfahren des Magazins (6) unmittelbar zu dessen zur Entnahme und Beschickung dienenden Seite benachbart angeordnet ist.

3. Vorrichtung nach Anspruch 1 oder 2, gekennzeichnet durch eine Einhausung (38) als Koppelelement zu einer Halbleiterbearbeitungsmaschine.

4. Vorrichtung nach Anspruch 3, dadurch gekennzeichnet, daß innerhalb der Einhausung (38) zusätzlich eine Lüfter-Filter-Einheit (39,40) zur Erzeugung eines Laminarluftstromes untergebracht ist.

5. Vorrichtung nach Anspruch 4, dadurch gekennzeichnet, daß der Laminarluftstrom senkrecht zur Bewegungsrichtung des Linearantriebes (7) gerichtet ist.

6. Vorrichtung nach Anspruch 4, dadurch gekennzeichnet, daß der Laminarluftstrom parallel zur Bewegungsrichtung des Linearantriebes (7) gerichtet ist.

7. Vorrichtung nach einem der Ansprüche 1 bis 6, dadurch gekennzeichnet, daß an Öffnungen, durch die der Greiferarm (8), seine greifenden Elemente (9) und das Element zur Aufnahme der Transportobjekte in den Reinstraum ragen, Absaugeinrichtungen (24,25;32,33) angrenzen.

## Claims

1. Device for transporting wafer magazines which are set down in a magazine container on a releasable base and together with a closure element of a take-up plate form an object for transport by a lift, which consists of a lift drive and a take-up element, between an upper removal position and a lower set-down position from which transfer to at least one processing location is effected, characterised in that a supporting column (1) is provided at a distance from the lift drive (2), forming an opening for air to pass through between the two, wherein for transfer of the magazine (6) a linear drive (7) for a rigid gripper arm (8) which is provided with gripping elements is mounted on the supporting column (1) so as to be variable in height in the direction of travel (z) of the lift, and wherein the said gripper arm is located above the magazine (6) when the latter is in the set-down position, bears a drive (28, 29) for the gripping elements (9) and is movable by the linear drive (7) perpendicular to the direction of travel (z) of the lift, and that the lift drive (2), as well as the linear drive (7) with gripper arm (8), gripping elements (9) and drive therefor (28, 29) are each constructed as modules which are encased so as to be dustproof.

2. Device as claimed in Claim 1, characterised in that for positioning of disc-shaped objects projecting out of the magazine (6) a wafer return device is provided, activation of which is associated with a sensor signal from a crash sensor (41) which has a measurement light beam directed parallel to the disc-shaped objects and during travel of the magazine (6) is disposed immediately adjacent to the side thereof which serves for removal and loading.

3. Device as claimed in Claim 1 or 2, characterised by an enclosure (38) as coupling element to a semiconductor processing machine.

4. Device as claimed in Claim 3, characterised in that a fan-filter unit (39, 40) is also accommodated within the enclosure (38) to produce a laminar air flow.

5. Device as claimed in Claim 4, characterised in that the laminar air flow is directed perpendicular to the direction of movement of the linear drive (7).

6. Device as claimed in Claim 4, characterised in that the laminar air flow is directed parallel to the direction of movement of the linear drive (7).

7. Device as claimed din one of Claims I to 6, characterised in that extraction arrangements (24, 25; 32, 33) adjoin openings through which the gripper arm (8), its gripping elements (9) and the element for take-up of the objects for transport project into the super-clean room.

## Revendications

1. Dispositif de transport de magasins à plaquettes de semi-conducteur qui sont déposés dans un conteneur de magasins sur un fond déverrouillable et qui avec un élément de fermeture d'une plaque de réception constituent un objet de transport pour un ascenseur, constitué d'un dispositif d'entraînement et d'un élément de réception, entre une position de prélèvement supérieure et une position de rangement inférieure, à partir de laquelle a lieu un transfert vers au moins un poste d'usinage, caractérisé en ce qu'à distance du dispositif d'entraînement d'ascenseur (2) est prévue une colonne (1) portante en formant entre eux deux une ouverture de passage d'air, sur la colonne (1) portante étant monté, pour le transfert du magasin (6), un dispositif d'entraînement linéaire (7) réglable en hauteur dans le sens de déplacement (z) de l'ascenseur, pour un bras de préhension (8) rigide, pourvu d'éléments de préhension, qui, lorsque le magasin (6) se trouve en position de rangement, se situe au-dessus de celui-ci, qui porte un dispositif d'entraînement (28, 29) pour les éléments de préhension (9) et qui est déplaçable par le dispositif d'entraînement linéaire (7), perpendiculairement à la direction de déplacement (z) de l'ascenseur, et en ce que le dispositif d'entraînement d'ascenseur (2), ainsi que le dispositif d'entraînement linéaire (7) avec bras de préhension (8), éléments de préhension (9) et leur dispositif d'entraînement (28, 29) sont réalisés chacun sous la forme de modules blindés de manière étanche à la poussière.

2. Dispositif selon la revendication 1, caractérisé en ce que pour le positionnement d'objets en plaquettes ressortant du magasin (6), il est prévu un dispositif de retour de plaquettes de semi-conducteur, dont l'entrée en action est liée à un signal provenant d'un capteur de collision (41), qui présente un faisceau de rayons de mesure orienté parallèlement aux objets en plaquettes et qui pour le déplacement du magasin (6) est disposé directement au voisinage de son côté servant au prélèvement et au chargement.

3. Dispositif selon la revendication 1 ou 2, caractérisé par une protection (38) servant d'élément de couplage avec une machine à usiner les semi-conducteurs.

4. Dispositif selon la revendication 3, caractérisé en ce qu'à l'intérieur de la protection (38) est logée en supplément une unité à filtre et ventilateur (39, 40) destinée à produire un courant d'air laminaire.

5. Dispositif selon la revendication 4, caractérisé en ce que le courant d'air laminaire est orienté perpendiculairement à la direction de déplacement du dispositif d'entraînement linéaire (7).

6. Dispositif selon la revendication 4, caractérisé en ce que le courant d'air laminaire est orienté parallèlement à la direction de déplacement du dispositif d'entraînement linéaire (7).

7. Dispositif selon l'une des revendications 1 à 6, caractérisé en ce que des dispositifs d'aspiration (24, 25; 32, 33) sont adjacents à des ouvertures à travers lesquelles le bras de préhension (8), ses éléments de préhension (9) et l'élément destiné à recevoir les objets de transport pénètrent dans la chambre blanche.
